# EUROPÄISCHE PATENTSCHRIFT

(11) **EP 0 787 330 B1**
(45) Veröffentlichungstag und Bekanntmachung des Hinweises auf die Patenterteilung: **29.07.1998**
(21) Anmeldenummer: 95937807.6
(22) Anmeldetag: 20.10.1995
(51) Int. Cl.: G06F 17/50

(54) **VERFAHREN ZUM AUFFINDEN UND ZUR DARSTELLUNG VON SCHALTUNGSELEMENTEN EINER ELEKTRONISCHEN SCHALTUNG FÜR DIE FUNKTIONSPRÜFUNG DER SCHALTUNG**
METHOD OF FINDING AND DISPLAYING COMPONENTS OF AN ELECTRONIC CIRCUIT IN ORDER TO TEST THE OPERATION OF SAID CIRCUIT
PROCEDE DE RECHERCHE ET D'AFFICHAGE D'ELEMENTS D'UN CIRCUIT ELECTRONIQUE EN VUE DU CONTROLE DU FONCTIONNEMENT DU CIRCUIT

(30) Priorität: 21.10.1994 DE 4437744
(43) Veröffentlichungstag der Anmeldung: 06.08.1997
(73) Patentinhaber: TEST PLUS ELECTRONIC GMBH, D-80337 München (DE)
(72) Erfinder: OTT, Rainer, D-80337 München (DE)
(74) Vertreter: Körber, Wolfhart, Dr. rer.nat.
(86) Internationale Anmeldenummer: EP9504120
(87) Internationale Veröffentlichungsnummer: WO9613010

(56) Entgegenhaltungen:
- EP-A- 0 550 812
- PROCEEDINGS OF THE IEEE 1993 CUSTOM INTEGRATED CIRCUITS CONFERENCE, 9.Mai 1993 SAN DIEGO CA US, Seiten 1321-1324, YAMAGISHI ET AL 'a multi-representational design data capture system'
- PROCEEDINGS EIGHTH INTERNATIONAL CONFERENCE ON DATA ENGINEERING, 3.Februar 1992 TEMPE ARIZONA US, Seiten 40-47, LEE ET AL 'an efficient object-based algorithm for spatial searching, insertion and deletion'

## Beschreibung

### Begriffsdefinitionen:

**interne Schaltplan-Daten:**
   CAD-Datei und eventuell zusätzliche Zwischendatei in einem internen Datenformat des jeweiligen CAD-Systems.
**grafische Schaltplan-Daten:**
   weitgehend standardisierte, für den Anwender bestimmte Ausgabedatei zur grafischen Darstellung des Schaltplanes.
**Schaltungselemente:**
   beliebige Elemente der Schaltung: Bauteile, Bauteilanschlüsse (Pins), Netze.
**Schaltungsnetze:**
   die die Bauteilanschlüsse verbindenden elektrisch leitenden Verbindungen.
**Bauteilbeschriftungen ("Label"):**
   in den grafischen Schaltplan-Daten eventuell als Texdatei enthaltene Bauteilbezeichnungen.
**Schaltplankoordinaten:**
   Schaltplanseite und X-Y-Koordinaten oder Rasterfeldangaben eines Schaltungselements auf einem Schaltplan.
**Funktionsprüfung:**
   Mit der Vorbereitung, der Durchführung und der Auswertung zusammenhängende Prozeßschritte der Funktionsprüfung elektronischer Baugruppen. Die Vorbereitung umfaßt auch die Erstellung von Prüfprogrammen und Prüfautomaten.

Die Erfindung betrifft ein Verfahren zum Auffinden und zur Darstellung von Schaltungselementen einer elektronischen Schaltung für die Funktionsprüfung der Schaltung, deren Schaltplan-Information als interne Daten beliebigen Formats und als grafische Daten zur Erstellung eines Schaltplanes gespeichert sind.

In vielen Bereichen der Produktion, Funktionsüberprüfung und Überwachung elektronischer Schaltungen spielt ein schneller Zugriff auf die Schaltbilddarstellung einer elektronischen Baugruppe der Schaltung eine wichtige Rolle. Es ist daher üblich, die auf Papier gezeichneten Schaltpläne heranzuziehen. Bei umfangreichen Schaltungen, die sich insbesondere über mehrere Seiten verteilen, kann die Suche des gewünschten Bauelementes oder der gewünschten Baugruppe sehr zeitaufwendig und damit teuer werden. Es ist daher vorteilhaft, solche Schaltungen, deren Schaltplan-Information als grafische Ausgabedateien für die Schaltplanerstellung vorhanden sind, auf dem Bildschirm darzustellen. Die Vorteile einer Bildschirmdarstellung der Schaltplan-Information einer zu überprüfenden oder zu reparierenden Schaltung kommen jedoch erst dann voll zum Tragen, wenn ein leichtes Auffinden eines bestimmten Bauteiles, Netzknotens oder einer Baugruppe gewährleistet ist.

Die ist jedoch im Stand der Technik nur dann möglich, wenn ein Suchbegriff als Textinformation in der Grafikdatei enthalten ist, das heißt, die Bezeichnung eines Bauteiles ist zum Beispiel als "Label"-Befehl in Textformat in der Grafik-Ausgabedatei gespeichert ist.

Eine derartige Bauteilauswahl aufgrund von Daten im Textformat in der Grafik-Ausgabedatei ist beispielsweise in den "Proceedings of the IEEE 1993, Custom Integrated Circuits Conference, 9. Mai 1993, 1321, 1323" beschrieben. Durch Auswahl von auf dem Bildschirm angezeigten Textdaten können die dem ausgewählten Bauelement zugehörigen Daten angezeigt werden.

Weiterhin ist in der genannten Entgegenhaltung die Bildschirmdarstellung von internen CAD-Daten durch Auswahl eines auf dem Bildschirm angezeigten hierarchischen Blockes beschrieben. Dabei muß jedoch direkt auf auf die umfangleichen internen CAD-Daten zugegriffen werden.

Die Aufgabe der Erfindung liegt demnach darin, ein Verfahren vorzuschlagen, das ein Auffinden und die anschließende Darstellung beliebiger Schaltungselemente oder Baugruppen einer Schaltung ermöglicht, deren Schaltplaninformation als grafische Ausgabedaten und als interne Schaltplandaten beliebigen Formats gespeichert sind.

Diese Aufgabe wird durch die in Anspruch 1 beschriebenen Merkmale gelöst.

Aus den grafischen Ausgabedaten wird ein Schaltplanausschnitt auf dem Bildschirm dargestellt. Aus den internen Schaltplan-Daten werden die Schaltplankoordinaen beliebiger Schaltungselemente ermittelt und in einer Suchdatei gespeichert. Durch Zugriff auf diese Suchdatei können ausgewählte Schaltungselemente gesucht und auf einem Bildschirm dargestellt werden. Die Kennzeichnung erfolgt durch Auswahl des richtigen Schaltplanausschnittes und optional durch zusätzliche Markierung des Schaltungselementes oder seiner Umgebung.

Ein Vorteil der Erfindung liegt darin, daß ein schnelles und einfaches Auffinden und Darstellen beliebiger Elemente der untersuchten Schaltung möglich ist. Ein weiterer Vorteil liegt darin, daß aus den internen Schaltplan-Daten nur einzelne Koordinaten und nicht der gesamte grafische Bildaufbau ermittelt wird, so daß eine wesentlich einfachere Anpassung an verschiedene CAD-interne-Datenformate ermöglicht wird.

Die in der Suchdatei enthaltenen Koordinaten der auf dem Bildschirmausschnitt dargestellten Schaltungselemente können zusätzlich z.B. durch Einblenden von kleinen, farblich unterschiedlichen Symbolen am Bildschirm sichtbar gemacht werden. Durch graphisches Anwählen ("Anklicken") der Markierungen können die jeweiligen Schaltungselemente angewählt oder gespeicherte Informationen dazu abgerufen werden.

Als Schaltungselemente der Schaltung sind Bauteile, Bauteilanschlüsse, Bauteilsymbole, Bauteilbeschriftungen, Verbindungslinien, Verbindungspunkte, Prüfpunkte und/oder Netzknoten darstellbar.

Die Position eines Schaltungselements in der Suchdatei kann beispielsweise aus dem Anfangspunkt eines zur Schaltplandarstellung benutzten grafischen Symbols ermittelt werden.

Es ist außerdem möglich, gespeicherte zusätzliche Inforrnation über ausgewählte Bauteile und/oder Netzknoten darzustellen. Dabei ist z.B. auch die Anzeige der dem Netzknoten zugeordneten Testkanalnummern des Prüfadapters vorteilhaft. Zur besseren Erkennbarkeit können ausgewählte Schaltungselemente auf dem Bildschirm grafisch hervorgehoben, zum Beispiel farblich kontrastiert, dargestellt werden.

Im folgenden wird ein Ausführungsbeispiel des erfindungsgemäßen Verfahrens anhand der Figuren dargestellt, in denen
- Figur 1: einen Auszug aus dem Schaltbild einer elektronischen Baugruppe,
- Figur 2: die Bildschirmdarstellung eines Schaltplanausschnittes nach Auswahl eines Bauteilanschlusses,
- Figur 3: die Bildschirmdarstellung aus Fig. 2 mit markierten Schaltplankoordinaten einiger Schaltungselemente,
- Figur 4: eine Bildschirmdarstellung mit grafischer Hervorhebung eines Netzknotens,
- Figur 5: eine schematische Darstellung eines Verfahrens zur Ermittlung einer Bauteilanschlußpositionen zeigt.

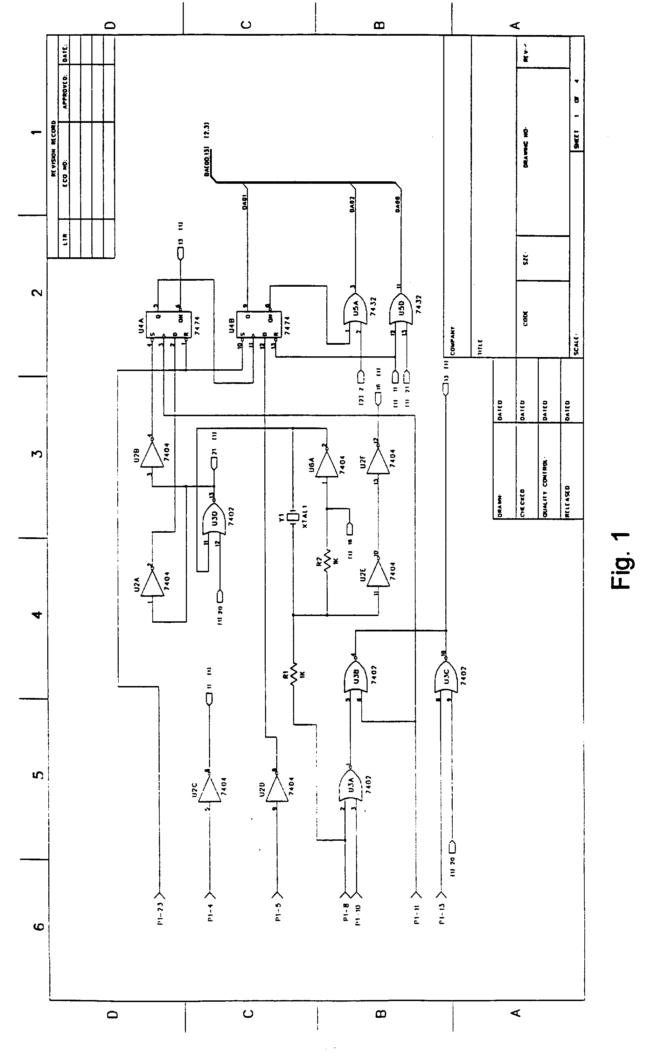

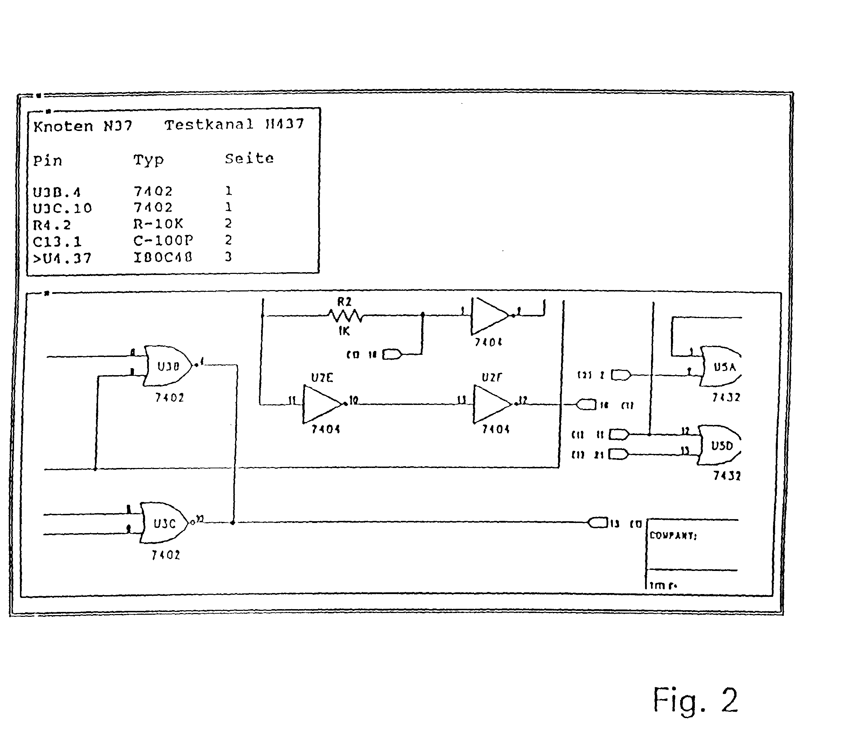

Figur 1 zeigt als Beispiel einen Auszug aus dem Schaltbild einer zu prüfenden oder zu reparierenden elektronischen Baugruppe. Nach dem Auswählen eines Bauteiles oder Bauteilanschlusses (im Beispielfall Anschluß 4 des Bauteiles U3B) erhält man die in Figur 2 gezeigte Bildschirmdarstellung. Zusätzlich werden in einem weiteren Kasten oben links alle Bauelementanschlüsse und zugehörigen Bauelementtypen des Netzknotens (N37), der mit dem gewählten Bauelementanschluß verbunden ist, mit der jeweiligen Schaltplanseite angegeben. Durch ein ">"-Symbol wird die Position einer Prüfnadel und die zugehörige Testkanalnummer des Prüfadapters hervorgehoben.

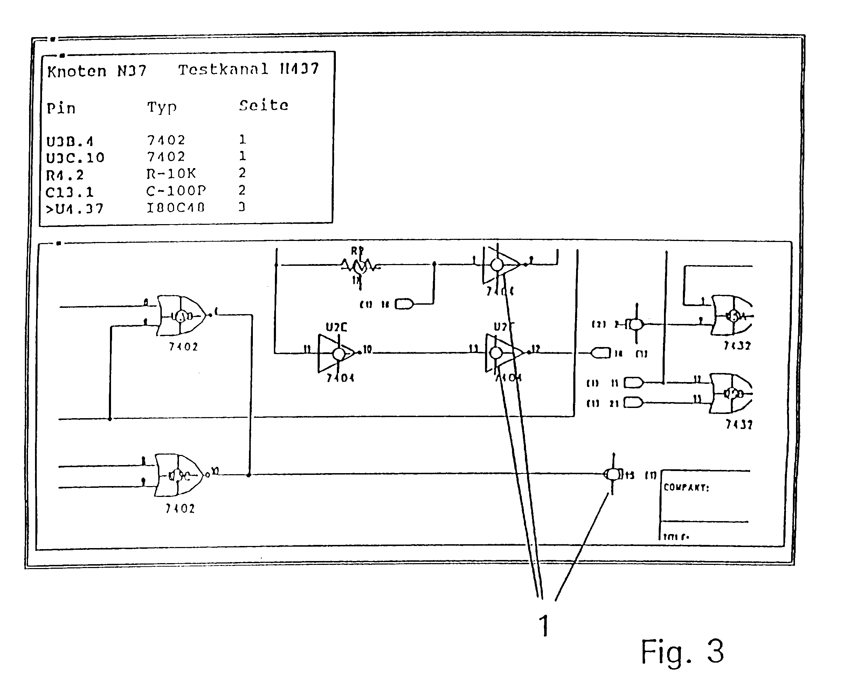

Dem auf dem Bildschirm dargestellten Schaltplanausschnitt können, wie in Fig. 3 dargestellt ist, die Markierungen 1 der Schaltplankoordinaten der in der Suchdatei enthaltenen Schaltungselemente überlagert werden. Durch "Anklicken" dieser Markierungen 1 auf dem Bildschirm läßt sich eines der Schaltelemente auswählen und zusätzliche Information wie Bauelementtyp oder am Netzknoten angeschlossene Bauelemente in einem zusätzlichen Bildschirmfenster darstellen.

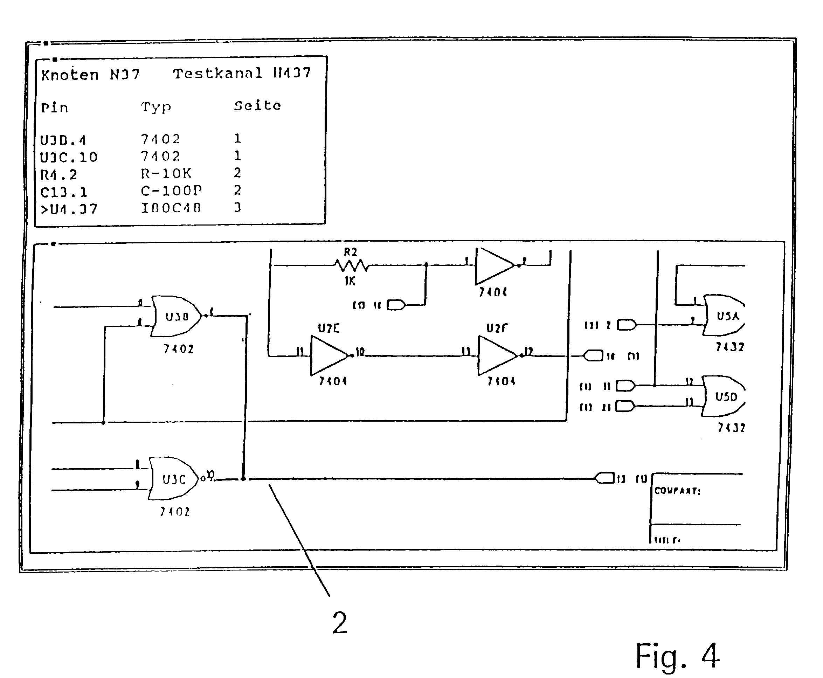

Durch Anwählen einzelner Bauteilanschlüsse mittels "Anklicken" am Bildschirm oder über die Tastatur kann, wie in Figur 4 gezeigt ist, das zugehörige Schaltungsnetz 2 des Bauteilanschlusses grafisch hervorgehoben, insbesondere farblich kontrastiert, dargestellt werden. Durch farblich unterschiedliche Markierungen kann beispielsweise die Zuordnung zu unterschiedlichen Meßkanälen ermöglicht werden. Diese so übersichtlich markierten Verbindungsnetze können dann auch als Datei abgespeichert und ausgegeben werden.

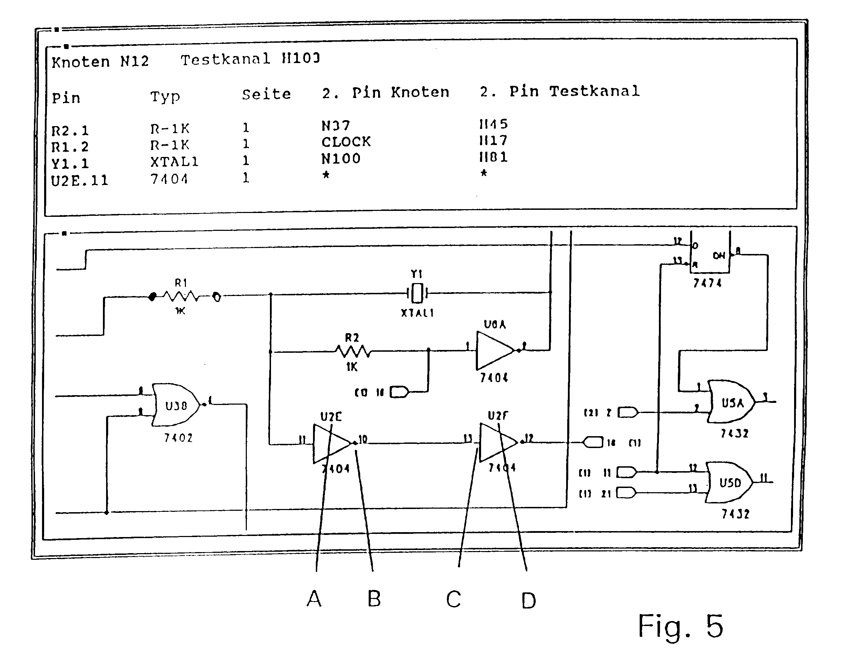

In auswertbaren Zwischendateien der internen Schaltplandaten sind oft nur die zum Schaltplanaufbau unbedingt notwendigen Informationen enthalten. Figur 5 illustriert ein Verfahren, mit dem die in der Zwischendatei nicht enthaltene genaue Position der Bauteilanschlüsse (U2E.10, U2F.13) zweier Bauelteile (U2E, U2F) aus den in den internen Schaltplandaten enthaltenen Endpunkten der Verbindungslinie B, C und den ebenfalls enthaltenen Bauteilbeschriftungen ermittelt wird. Aus den Daten läßt sich auch ermitteln, daß die beiden Bauelemente (U2E, U2F) ein gemeinsames Netz bilden. Aufgrund des geringeren Abstandes zu den Positionen A bzw. D der Bauteilbeschriftungen kann das Ende B der Verbindungslinie als Position des Pins U2E. 10 des Bauteils U2E und das Verbindungsende C als Position des Pins U2F.13 des Bauelements U2F identifiziert werden. So kann die in den internen CAD-Daten nicht enthaltene genaue Position der Bauteilanschlüsse U2E. 10 und U2F. 13 ermittelt werden.

## Patentansprüche

1. Verfahren zur Erzeugung einer Schaltbilddarstellung eines ausgewählten Schaltungselements einer zu prüfenden elektronischen Schaltung auf einem Bildschirm, wobei die Schaltplan-Information der Schaltung als graphische Ausgabedaten zur Erstellung eines Schaltplanes und als interne Schaltplandaten beliebigen Formats, CAD-Daten, gespeichert ist, **dadurch gekennzeichnet**, daß
aus den gespeicherten internen Schaltplandaten der Schaltung die Schaltplankoordinaten des ausgewählten Schaltungselements ermittelt und in einer Suchdatei abgespeichert werden, und
durch Verknüpfung der in der Suchdatei gespeicherten Koordinaten mit den graphischen Ausgabedaten das ausgewählte Schaltungselement am Bildschirm angezeigt wird.

2. Verfahren nach Anspruch 1, **dadurch gekennzeichnet**, daß die Schaltplankoordinaten des angezeigten Schaltungselements auf dem Bildschirm zusätzlich markiert sind.

3. Verfahren nach Anspruch 1 oder 2, **dadurch gekennzeichnet**, daß ein Schaltungselement durch graphisches Anwählen am Bildschirm auswählbar ist.

4. Verfahren nach einem der Ansprüche 1 bis 3, **dadurch gekennzeichnet**, daß als ausgewählte Schaltungselemente Bauteile, Bauteilanschlüsse, Bauteilsymbole, Bauteilbeschriftungen, Verbindungslinien, Verbindungspunkte, Prüfpunkte und/oder Netzknoten der Schaltung aufgefunden und angezeigt werden können.

5. Verfahren nach einem der Ansprüche 1 bis 4, **dadurch gekennzeichnet**, daß die Schaltplankoordinaten eines Schaltungselements in der Suchdatei aus den Koordinaten eines zur Schaltplandarstellung benutzten grafischen Symbols ermittelt werden.

6. Verfahren nach einem der Ansprüche 1 bis 5, **dadurch gekennzeichnet**, daß gespeicherte zusätzliche Information über ausgewählte Bauteile und/oder Netzknoten auf dem Bildschirm angezeigt wird.

7. Verfahren nach einem der Ansprüche 1 bis 6, **dadurch gekennzeichnet**, daß ausgewählte Schaltungselemente und/oder markierte Koordinatenpositionen auf dem Bildschirm grafisch hervorgehoben, etwa farblich kontrastiert, dargestellt werden.

## Claims

1. A method for generating a display of a circuit diagram of a selected circuit element of an electronic circuit to be tested on a screen, wherein the circuit diagram information of the circuit is stored as graphical output data for generating a circuit diagram and as internal circuit diagram information having an arbitrary format, CAD data,
**characterised in that**
the circuit diagram coordinates of the selected circuit element are determined from the stored internal circuit diagram data of the circuit and are stored in a search file, and the selected circuit element is displayed on the screen by linking the coordinates stored in the search file with the graphical output data.

2. A method according to claim 1,
**characterised in that**
the circuit diagram coordinates of the displayed circuit element are also marked on the screen.

3. A method according to claim 1 or 2,
**characterised in that**
a circuit diagram can be selected by clicking on a graphic on the screen.

4. A method according to any one of claims 1 to 3,
**characterised in that**
components, component connections, component symbols, component designations, connecting lines, connection points, test points and/or network nodes of the circuit can be found and displayed as selected circuit elements.

5. A method according to any one of claims 1 to 4,
**characterised in that**
the circuit diagram coordinates of a circuit element in the search file are determined from the coordinates of a graphic symbol used to display the circuit diagram.

6. A method according to any one of claims 1 to 5,
**characterised in that**
additional stored information on selected components and/or network nodes is displayed on the screen.

7. A method according to any one of claims 1 to 6,
**characterised in that**
selected circuit elements and/or marked coordinate positions are displayed on the screen such that they are graphically highlighted, for instance they are allocated contrasting colours.

## Revendications

1. Procédé destiné à produire une représentation sous forme d'un schéma de montage d'un élément de circuit sélectionné d'un circuit électronique à vérifier, sur un écran, l'information de schéma de montage du circuit étant mémorisée en tant que données graphiques de sortie pour l'établissement d'un schéma de montage et en tant que données internes de schéma de montage, d'un format quelconque (données CAD), caractérisé en ce que les coordonnées de schéma de montage de l'élément de circuit sélectionné sont déterminées à partir des données internes mémorisées du schéma de montage et sont mémorisées dans un fichier de recherche, et l'élément de circuit sélectionné est affiché sur l'écran, par corrélation des coordonnées mémorisées dans le fichier de recherche avec les données de sortie graphiques.

2. Procédé selon la revendication 1, caractérisé en ce que les coordonnées de schéma de montage de l'élément de circuit affiché sont en plus marquées sur l'écran.

3. Procédé selon la revendication 1 ou 2, caractérisé en ce qu'un élément de circuit peut être sélectionné par sélection graphique sur l'écran.

4. Procédé selon l'une des revendications 1 à 3, caractérisé en ce qu'on peut trouver et afficher sur l'écran, comme éléments de circuit sélectionnés, des composants, des branchements de composants, des symboles de composants, des inscriptions de composants, des lignes de liaison, des points de liaison, des points de vérification et/ou des noeuds de réseau du circuit.

5. Procédé selon l'une des revendications 1 à 4, caractérisé en ce que les coordonnées de schéma de montage d'un élément de circuit sont déterminées dans le fichier de recherche à partir des coordonnées d'un symbole graphique utilisé pour la représentation sous forme d'un schéma de montage.

6. Procédé selon l'une des revendications 1 à 5, caractérisé en ce qu'une information supplémentaire mémorisée concernant des composants et/ou des noeuds de réseau sélectionnés est affichée sur l'écran.

7. Procédé selon l'une des revendications 1 à 6, caractérisé en ce que des éléments de circuit sélectionnés et/ou des positions de coodonnées marquées sont mis en relief graphiquement sur l'écran, par exemple représentés par des couleurs contrastées.
